(19) **Europäisches Patentamt**
**European Patent Office**
**Office européen des brevets**

(11) **EP 4 229 422 B1**

(12) **EUROPÄISCHE PATENTSCHRIFT**

(45) Veröffentlichungstag und Bekanntmachung des Hinweises auf die Patenterteilung:
**28.01.2026 Patentblatt 2026/05**

(21) Anmeldenummer: **21787415.5**

(22) Anmeldetag: **06.10.2021**

(51) Internationale Patentklassifikation (IPC):
*G01R 31/327* (2006.01) *H01H 9/16* (2006.01)

(52) Gemeinsame Patentklassifikation (CPC):
**H01H 9/16; G01R 31/3277; H01H 9/167;**
H01H 2239/012

(86) Internationale Anmeldenummer:
**PCT/EP2021/077514**

(87) Internationale Veröffentlichungsnummer:
**WO 2022/078831 (21.04.2022 Gazette 2022/16)**

(54) **EINGABEVORRICHTUNG FÜR EIN KRAFTFAHRZEUG MIT EINER SPANNUNGSBASIERTEN FEHLERERKENNUNG**

INPUT DEVICE FOR A MOTOR VEHICLE WITH VOLTAGE-BASED ERROR DETECTION

DISPOSITIF D'ENTRÉE POUR UN VÉHICULE À MOTEUR, POURVU D'UNE DÉTECTION D'ERREUR À BASE DE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.10.2020 DE 102020126777**

(43) Veröffentlichungstag der Anmeldung:
**23.08.2023 Patentblatt 2023/34**

(73) Patentinhaber: **Valeo Schalter und Sensoren GmbH**
**74321 Bietigheim-Bissingen (DE)**

(72) Erfinder:
• **STAUDE, Sascha**
**74321 Bietigheim-Bissingen (DE)**

• **LEUCHT, Florian**
**74321 Bietigheim-Bissingen (DE)**
• **DIETZ, Benjamin**
**74321 Bietigheim-Bissingen (DE)**
• **MACK, Raphael**
**74321 Bietigheim-Bissingen (DE)**

(74) Vertreter: **Ralf, Thorge**
**Valeo Schalter und Sensoren GmbH**
**Laiernstraße 12**
**74321 Bietigheim-Bissingen (DE)**

(56) Entgegenhaltungen:
**DE-A1- 102008 044 115    DE-A1- 102017 113 905**
**DE-A1- 102018 208 577**

**Beschreibung**

Die Erfindung betrifft eine Eingabevorrichtung für sicherheitsrelevante Funktionen eines Kraftfahrzeuges. Die Eingabevorrichtung umfasst ein Schaltelement, welches einen Schaltkontakt mit einem ersten Anschluss sowie einen Gegenkontakt mit einem zweiten Anschluss aufweist. Bei Betätigung der Eingabevorrichtung wird der Schaltkontakt mit dem Gegenkontakt kontaktiert. Außerdem umfasst die Eingabevorrichtung einen ersten Widerstand sowie einen ersten und einen zweiten Spannungsversorgungsanschluss, über die eine Betriebsspannung für die Eingabevorrichtung bereitstellbar ist. Dabei ist der erste Spannungsversorgungsanschluss mit einem der Anschlüsse des Schaltelements verbunden und der zweite Spannungsversorgungsanschluss über den ersten Widerstand mit dem jeweils anderen Anschluss des Schaltelements verbunden. Ferner weist die Eingabevorrichtung einen Messknoten auf, welcher zwischen dem ersten Widerstand und dem jeweiligen Anschluss des Schaltelements vorgesehen ist und welcher mit einem Messanschluss verbunden ist. Dadurch ist eine betätigungsabhängige Spannung über den Messanschluss erfassbar, welche von der Betätigung der Eingabevorrichtung abhängig ist.

Aus dem Stand der Technik sind bereits Eingabevorrichtungen mit entsprechenden Schaltelementen bekannt. So offenbart die US 6 423 918 B1 eine Eingabevorrichtung mit einem Schaltelement, welches einen dom- oder kuppelförmigen Schaltkontakt aufweist, der bei Betätigung mit einem Gegenkontakt auf einer Leiterplatte in Kontakt gebracht wird. Der dom- oder kuppelförmige Schaltkontakt wird dabei über Halteelemente auf der Leiterplatte gehalten.

Die US 7 825 345 B1 offenbart eine Eingabevorrichtung in Form eines Mikroschalters, welcher rückseitig betätigt werden kann. Dazu weist der Mikroschalter in seinem Gehäuse ein dom- oder kuppelförmiges Schaltelement auf, welches bei Betätigung mit einem Gegenkontakt in dem Gehäuse in Kontakt gebracht wird. Die jeweiligen Kontakte sind mit Anschlüssen verbunden, welche außen am Gehäuse des Mikroschalters vorgesehen sind.

Die US 2014/0144765 A1 offenbart eine Eingabevorrichtung mit einem Schaltelement, welches einen dom- oder kuppelförmigen Schaltkontakt aufweist, der bei Betätigung mit einem Gegenkontakt auf einer Leiterplatte in Kontakt gebracht wird. Der dom- oder kuppelförmige Schaltkontakt wird dabei über Halteelemente auf der Leiterplatte gehalten.

Die EP 2 001 034 A2 offenbart eine Eingabevorrichtung mit einem Schaltelement, welches einen Schaltkontakt aufweist, der bei Betätigung mit einem Gegenkontakt auf einer Leiterplatte in Kontakt gebracht wird. Der Schaltkontakt ist über eine Elektrode mit einem ersten Spannungsversorgungsanschluss verbunden und der Gegenkontakt über einen ersten Widerstand mit einem zweiten Spannungsversorgungsanschluss verbunden. Die am Widerstand abfallende Spannung wird gemessen und ist ein Maß für die Betätigung der Eingabevorrichtung. Eine weitere Eingabevorrichtung ist aus der DE-A-102017113905 bekannt.

Nachteilig ist bei dem angeführten Stand der Technik, dass ein Fehler am Schaltkontakt nicht eindeutig und zuverlässig detektiert werden kann, da beispielsweise ein Bruch des Schaltkontaktes von einem Nichtbetätigen der Eingabevorrichtung nicht unterscheidbar ist. Das hat zur Folge, dass solche Eingabevorrichtungen nicht in sicherheitsrelevanten Anwendungen, beispielsweise beim autonomen Fahren eines Kraftfahrzeugs, verwendet werden können.

Von daher ist es Aufgabe der Erfindung die gattungsgemäßen Eingabevorrichtungen derart weiterzuentwickeln, so dass diese höhere Sicherheitsstandards erfüllen und somit für sicherheitsrelevante Anwendungen im Kraftfahrzeug verwendbar sind.

Gelöst wird diese Aufgabe durch die Lösung gemäß dem kennzeichnenden Teil von Anspruch 1.

Unter einem Fehler des Schaltkontaktes wird im Sinne dieser Erfindung der Bruch des Schaltkontaktes und/oder jede Änderung des Widerstandes des Schaltkontakts verstanden, der zu einer von den Schaltzuständen unterscheidbare Spannung am Messknoten führt. Das gilt insbesondere für den Fall, wenn der vorgenannt beschriebene Fehler in dem Bereich des Schaltkontaktes zwischen dem ersten und dritten Anschluss auftritt. In diesem Fall wird die elektrische Verbindung zwischen dem ersten und dritten Anschluss durch den Fehler beeinflusst.

In einer vorteilhaften Ausgestaltung der erfindungsgemäßen Eingabevorrichtung ist eine Auswerteschaltung vorgesehen, welche über den Messanschluss die Spannung am Messknoten erfasst und dadurch eine Betätigung der Eingabevorrichtung und/oder einen Fehler des Schaltkontaktes erkennbar ist. Das hat den Vorteil, dass die verschiedenen Spannungen am Messknoten erkannt und entsprechend ausgewertet werden können, so dass der Zustand der Eingabevorrichtung eindeutig bestimmbar ist. Ein weiterer Vorteil von Auswerteschaltungen ist, dass diese die Informationen weiterverarbeiten können, beispielsweise durch einen Controller oder ein Steuergerät, welche Teil der Auswerteschaltung sein können, um entsprechende Funktionen im Fahrzeug auszulösen oder um entsprechende Warnungen auszugeben.

Alternativ oder zusätzlich kann es bei der erfindungsgemäßen Eingabevorrichtung vorgesehen sein, dass der Schaltkontakt dom- oder kuppelförmig ausgebildet ist und vorzugsweise der erste und dritte Anschluss an sich gegenüberliegenden Bereichen des dom- oder kuppelförmigen Schaltkontaktes vorgesehen sind. Das hat zum einen den Vorteil, dass durch den dom- oder kuppelförmigen Schaltkontakt bei Betätigung eine passive Haptik bzw. eine passive haptische Rückmeldung an den Betätiger erzeugt werden kann.

Der metallische Schaltkontakt weist durch die dom- oder kuppelförmige Form eine nichtlineare Verformungseigenschaft bei konstant steigender Betätigungskraft auf, im Sinne einer Schnappscheibe oder eines Knackfrosches. Dadurch gibt der Schaltkontakt bei Betätigung erst bei einem bestimmten Druckpunkt schlagartig nach, was zu einer entsprechenden haptischen Rückmeldung an den Betätiger führt. Nach dem Loslassen des Schaltkontaktes wird dieser wieder in den Ausgangszustand zurückgeführt.

Zum anderen hat die Anordnung des ersten und dritten Anschlusses an sich gegenüberliegenden Bereichen des dom- oder kuppelförmigen Schaltkontaktes den Vorteil, dass die Fehlererkennung der erfindungsgemäßen Eingabevorrichtung verbessert ist. Denn durch diese Maßnahme ist die Fläche des Schaltkontaktes zwischen den Anschlüssen maximal oder zumindest vergrößert, so dass entsprechend jegliche Fehler innerhalb dieser Fläche detektiert werden können.

In einer weiteren vorteilhaften Ausgestaltung der erfindungsgemäßen Eingabevorrichtung ist der Schaltkontakt flächig ausgebildet. Vorzugsweise sind dabei der erste und dritte Anschluss benachbart an einer Kante oder an sich gegenüberliegenden Bereichen des flächigen Schaltkontaktes vorgesehen. Dabei kann der flächig ausgebildete Kontakt elastisch und/oder mit einer Prägung versehen sein, um eine haptische Rückmeldung beim Betätiger zu erzeugen. Mittels der Prägung kann auch hier eine nichtlineare Verformungseigenschaft bei konstant steigender Betätigungskraft bereitgestellt werden, im Sinne einer Schnappscheibe oder eines Knackfrosches.

Zum anderen hat die Anordnung des ersten und dritten Anschlusses an sich gegenüberliegenden Bereichen des flächigen Schaltkontaktes den Vorteil, dass die Fehlererkennung der erfindungsgemäßen Eingabevorrichtung verbessert ist. Denn durch diese Maßnahme ist die Fläche des Schaltkontaktes zwischen den Anschlüssen maximal oder zumindest vergrößert, so dass entsprechend jegliche Fehler innerhalb dieser Fläche detektiert werden können.

Alternativ oder zusätzlich kann bei der erfindungsgemäßen Eingabevorrichtung vorgesehen sein, dass ein dritter Widerstand zwischen dem ersten Spannungsversorgungsanschluss und dem jeweiligen Anschluss des Schaltelements vorgesehen ist, so dass der jeweilige Anschluss des Schaltelements über den dritten Widerstand mit dem ersten Spannungsversorgungsanschluss verbunden ist. Durch diesen zusätzlichen Widerstand ist die Betätigung des Schaltkontaktes mittels einer betätigungsabhängigen Spannung detektierbar, die sich von der Betriebsspannung bzw. von einem der Betriebsspannungspotentiale unterscheidet. Dadurch ist die Zuverlässigkeit der erfindungsgemäßen Eingabevorrichtung weiter verbessert, da nun die Betätigung von einem Schluss des Messanschlusses gegen eines der Betriebsspannungspotentiale im Fehlerfall unterscheidbar ist.

In einer weiteren vorteilhaften Ausgestaltung der erfindungsgemäßen Eingabevorrichtung ist der zweite Spannungsversorgungsanschluss mit einer positiven Betriebsspannung verbunden und der erste Spannungsversorgungsanschluss mit einem Bezugspotential, vorzugsweise Masse, der Eingabevorrichtung verbunden. Durch diese Maßnahme kann auf eine einfache Art und Weise die Betriebsspannung bereitgestellt werden. Alternativ kann dabei aber auch der erste Spannungsversorgungsanschluss mit einer positiven Betriebsspannung verbunden und der zweite Spannungsversorgungsanschluss mit einem Bezugspotential, vorzugsweise Masse, der Eingabevorrichtung verbunden sein.

Alternativ oder zusätzlich kann bei der erfindungsgemäßen Eingabevorrichtung vorgesehen sein, dass im unbetätigten Zustand der Eingabevorrichtung am Messknoten eine betätigungsabhängige Spannung erfassbar ist, welche aus dem Spannungsteilerverhältnis zwischen erstem Widerstand und zweitem Widerstand und vorzugsweise drittem Widerstand resultiert. Die betätigungsabhängige Spannung im unbetätigten Zustand berechnet sich dabei wie folgt mit $U_1$ als betätigungsabhängige Spannung, $U_B$ als positive Betriebsspannung, $R_1$ als erstem Widerstand, $R_2$ als zweitem Widerstand und $R_3$ als drittem Widerstand:

$$U_1 = U_B * \frac{R_2}{R_2 + R_1}$$

(Wenn $R_1$ an $U_B$ anliegt und ohne $R_3$)
oder

$$U_1 = U_B * \frac{R_1}{R_2 + R_1}$$

(Wenn $R_1$ an *Masse* anliegt und ohne $R_3$)
oder

$$U_1 = U_B * \frac{R_2 + R_3}{R_2 + R_1 + R_3}$$

(Wenn $R_1$ an $U_B$ anliegt und mit $R_3$)
oder

$$U_1 = U_B * \frac{R_1}{R_2 + R_1 + R_3}$$

(Wenn $R_1$ an *Masse* anliegt und mit $R_3$)

Das hat den Vorteil, dass sich die betätigungsabhängige Spannung vom Betätigungszustand oder dem Fehlerzustand deutlich unterscheidet und somit die Sicherheit der erfindungsgemäßen Eingabevorrichtung erhöht ist.

In einer weiteren vorteilhaften Ausgestaltung der erfindungsgemäßen Eingabevorrichtung ist im betätigten Zustand der Eingabevorrichtung am Messknoten eine betätigungsabhängige Spannung erfassbar, welche der Spannung bzw. dem Potential des ersten Spannungsversorgungsanschlusses entspricht oder aus dem Spannungsteilerverhältnis zwischen erstem Widerstand und drittem Widerstand resultiert. Die betätigungsabhängige Spannung im betätigten Zustand berechnet sich dabei wie folgt mit $U_1$ als betätigungsabhängige Spannung, $U_B$ als positive Betriebsspannung, $R_1$ als erstem Widerstand, $R_2$ als zweitem Widerstand und $R_3$ als drittem Widerstand:

$$U_1 = Masse$$

(Wenn $R_1$ an $U_B$ anliegt und ohne $R_3$)
oder

$$U_1 = U_B$$

(Wenn $R_1$ an *Masse* anliegt und ohne $R_3$)
oder

$$U_1 = U_B * \frac{R_3}{R_1 + R_3}$$

(Wenn $R_1$ an $U_B$ anliegt und mit $R_3$)
oder

$$U_1 = U_B * \frac{R_1}{R_1 + R_3}$$

(Wenn $R_1$ an *Masse* anliegt und mit $R_3$)

Das hat den Vorteil, dass sich die betätigungsabhängige Spannung vom unbetätigten Zustand oder dem Fehlerzustand deutlich unterscheidet und somit die Sicherheit der erfindungsgemäßen Eingabevorrichtung erhöht ist.

In einer weiteren vorteilhaften Ausgestaltung der erfindungsgemäßen Eingabevorrichtung ist bei einem Fehler des Schaltkontaktes, vorzugsweise bei einem Bruch des Schaltkontaktes insbesondere zwischen dem ersten und dritten Anschluss des Schaltkontaktes, und vorzugsweise bei Nichtbetätigung des Schaltkontaktes, am Messknoten eine Fehlerspannung erfassbar, welche der Spannung bzw. dem Potential des zweiten Spannungsversorgungsanschlusses entspricht. Die Fehlerspannung berechnet sich dabei wie folgt mit $U_2$ als Fehlerspannung, $U_B$ als positive Betriebsspannung, $R_1$ als erstem Widerstand, $R_2$ als zweitem Widerstand und $R_3$ als drittem Widerstand:

$$U_2 = U_B$$

(Wenn $R_1$ an $U_B$ anliegt und ohne $R_3$)

oder

$$U_2 = Masse$$

(Wenn $R_1$ an *Masse* anliegt und ohne $R_3$)
oder

$$U_2 = U_B$$

(Wenn $R_1$ an $U_B$ anliegt und mit $R_3$)
oder

$$U_2 = Masse$$

(Wenn $R_1$ an *Masse* anliegt und mit $R_3$)

Das hat den Vorteil, dass sich die Fehlerspannung vom unbetätigten Zustand oder dem betätigten Zustand deutlich unterscheidet und somit die Sicherheit der erfindungsgemäßen Eingabevorrichtung erhöht ist.

In einer weiteren vorteilhaften Ausgestaltung der erfindungsgemäßen Eingabevorrichtung umfasst die Auswerteeinheit einen Analog-Digital-Wandler, so dass die erfasste betätigungsabhängige Spannung in einen digitalen Wert wandelbar und digital verarbeitbar ist. Digitale Werte von gemessenen Spannungen sind besonders unempfindlich gegenüber Störeinflüssen, so dass auch damit die Sicherheit der erfindungsgemäßen Eingabevorrichtung erhöht ist. Des Weiteren können digitale Werte besonders effektiv weiterverarbeitet werden, um beispielsweise eine Plausibilisierung durchzuführen, die wiederrum die Sicherheit der erfindungsgemäßen Eingabevorrichtung erhöht.

Alternativ oder zusätzlich kann bei der erfindungsgemäßen Eingabevorrichtung vorgesehen sein, dass bei Betätigung der Eingabevorrichtung die Kontaktierung zwischen Schaltkontakt und Gegenkontakt galvanisch bzw. elektrisch leitend ist. Das bedeutet, dass der Schaltkontakt und der Gegenkontakt derart zueinander positioniert werden, so dass eine elektrisch leitfähige Verbindung hierzwischen hergestellt ist. Insbesondere ist hiermit ein direkter elektrischer Kontakt zwischen Schaltkontakt und Gegenkontakt gemeint. Durch diese Art der Kontaktierung wird in besonders vorteilhafter Art und Weise eine zuverlässige Kontaktierung geschaffen, die eindeutig unterscheidbare Spannungswerte am Messknoten liefert.

In einer besonders vorteilhaften Ausgestaltung der erfindungsgemäßen Eingabevorrichtung ist bei Betätigung der Eingabevorrichtung die Kontaktierung zwischen Schaltkontakt und Gegenkontakt resistiv oder kapazitiv. Das bedeutet gemäß der ersten Alternative, dass die Kontaktierung zwischen Schaltkontakt und Gegenkontakt über ein resistives Element, wie beispielsweise ein Widerstandsmaterial oder eine entsprechende Beschichtung erfolgt. Das hat den Vorteil, dass ein zusätzliches Widerstandselement bei Betätigung eingebracht wird, welches mit dem zweiten Widerstand zusammenwirkt und so besonders zuverlässig unterscheidbare Spannungswerte am Messknoten liefert.

Gemäß der zweiten Alternative kann die Kontaktierung auch über ein kapazitives Element, beispielsweise einen Kondensator, erfolgen, so dass bei Verwendung einer Wechselspannung als Betriebsspannung und einer entsprechenden Betätigung der Übergang zwischen Schaltkontakt und Gegenkontakt niederohmig wird. Auch dadurch können in vorteilhafter Art und Weise zuverlässig unterscheidbare Spannungswerte am Messknoten bereitgestellt werden.

Alternativ oder zusätzlich sind bei der erfindungsgemäßen Eingabevorrichtung das Schaltelement und die Widerstände auf einer Leiterplatte angeordnet und vorzugsweise zumindest der erste und dritte Anschluss als Lötpunkte auf der Leiterplatte ausgeführt. Durch diese Maßnahme kann die erfindungsgemäße Eingabevorrichtung besonders kompakt ausgeführt bereitgestellt werden.

In einer weiteren vorteilhaften Ausgestaltung der erfindungsgemäßen Eingabevorrichtung ist der dom- oder kuppelförmige Schaltkontakt mit den Lötpunkten für den ersten und dritten Anschluss verlötet und der Gegenkontakt zwischen diesen beiden Lötpunkten auf der Leiterplatte vorgesehen. Durch diese Maßnahme kann sich der dom- oder kuppelförmige Schaltkontakt in vorteilhafter Art und Weise auf der Leiterplatte abstützen, um im Sinne einer Schnappscheibe eine haptische Rückmeldung an den Betätiger zurückzugeben. Der zwischen den Lötpunkten angeordnete Gegenkontakt sorgt dabei für einen zuverlässigen Kontakt bei Betätigung zwischen Schaltkontakt und Gegenkontakt sowie eine kompakte Bauform der erfindungsgemäßen Eingabevorrichtung.

Bei einer weiteren vorteilhaften Ausgestaltung der erfindungsgemäßen Eingabevorrichtung sind weitere Auflagepunkte für den dom- oder kuppelförmigen Schaltkontakt vorgesehen, welche vorzugsweise als Lötpunkte ausgeführt sind. Dadurch wird der dom- oder kuppelförmige Schaltkontakt besonders sicher auf der Leiterplatte gehalten, so dass die Sicherheit der erfindungsgemäßen Eingabevorrichtung insgesamt verbessert ist.

Die Erfindung wird nun anhand bevorzugter Ausführungsbeispiele näher erläutert, insbesondere unter Bezugnahme auf die beigefügten Zeichnungen. Dabei zeigen

Fig. 1a schematisch das Schaltbild eines ersten vorteilhaften Ausführungsbeispiels der erfindungsgemäßen Eingabevorrichtung im unbetätigten Zustand des Schaltelements,

Fig. 1b schematisch das Schaltbild des ersten vorteilhaften Ausführungsbeispiels der erfindungsgemäßen Eingabevorrichtung im unbetätigten Zustand des Schaltelements,

Fig. 1c schematisch das Schaltbild des ersten vorteilhaften Ausführungsbeispiels der erfindungsgemäßen Eingabevorrichtung bei einem Fehler am Schaltelement,

Fig. 2a schematisch das Schaltbild eines zweiten vorteilhaften Ausführungsbeispiels der erfindungsgemäßen Eingabevorrichtung im unbetätigten Zustand des Schaltelements,

Fig. 2b schematisch das Schaltbild des zweiten vorteilhaften Ausführungsbeispiels der erfindungsgemäßen Eingabevorrichtung im unbetätigten Zustand des Schaltelements,

Fig. 2c schematisch das Schaltbild des zweiten vorteilhaften Ausführungsbeispiels der erfindungsgemäßen Eingabevorrichtung bei einem Fehler am Schaltelement,

Fig. 3a schematisch das Schaltbild eines dritten vorteilhaften Ausführungsbeispiels der erfindungsgemäßen Eingabevorrichtung im unbetätigten Zustand des Schaltelements,

Fig. 3b schematisch das Schaltbild des dritten vorteilhaften Ausführungsbeispiels der erfindungsgemäßen Eingabevorrichtung im unbetätigten Zustand des Schaltelements,

Fig. 3c schematisch das Schaltbild des dritten vorteilhaften Ausführungsbeispiels der erfindungsgemäßen Eingabevorrichtung bei einem Fehler am Schaltelement,

Fig. 4a schematisch das Schaltbild eines vierten vorteilhaften Ausführungsbeispiels der erfindungsgemäßen Eingabevorrichtung im unbetätigten Zustand des Schaltelements,

Fig. 4b schematisch das Schaltbild des vierten vorteilhaften Ausführungsbeispiels der erfindungsgemäßen Eingabevorrichtung im unbetätigten Zustand des Schaltelements,

Fig. 4c schematisch das Schaltbild des vierten vorteilhaften Ausführungsbeispiels der erfindungsgemäßen Eingabevorrichtung bei einem Fehler am Schaltelement,

Fig. 5a schematisch ein fünftes vorteilhaftes Ausführungsbeispiel der erfindungsgemäßen Eingabevorrichtung mit einer Leiterplatte,

Fig. 5b eine Schnittansicht durch die Leiterplatte der erfindungsgemäßen Eingabevorrichtung gemäß dem fünften Ausführungsbeispiel,

Fig. 6a schematisch ein sechstes vorteilhaftes Ausführungsbeispiel der erfindungsgemäßen Eingabevorrichtung mit einer Leiterplatte, und

Fig. 6b eine Schnittansicht durch die Leiterplatte der erfindungsgemäßen Eingabevorrichtung gemäß dem sechsten Ausführungsbeispiel.

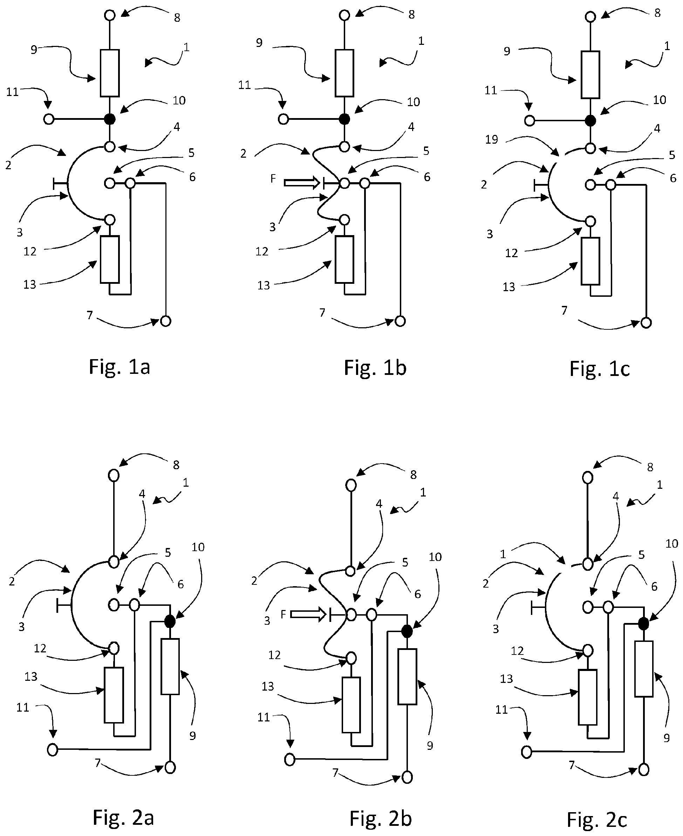

Fig. 1a zeigt schematisch das Schaltbild eines ersten vorteilhaften Ausführungsbeispiels der erfindungsgemäßen Eingabevorrichtung (1) im unbetätigten Zustand. Die Eingabevorrichtung (1) weist ein Schaltelement (2) mit einem dom- oder kuppelförmigen Schaltkontakt (3) auf, der bei Betätigung mit einem Gegenkontakt (5) kontaktierbar ist. Das Schaltelement (2) weist am dom- oder kuppelförmigen Schaltkontakt (3) einen ersten Anschluss (4) auf, an dem ein erster Widerstand (9) gegen einen zweiten Spannungsversorgungsanschluss (8) angeschlossen ist. In diesem Beispiel ist die hier angelegte Betriebsspannung $U_B$ positiv. Zwischen dem ersten Widerstand (9) und dem ersten Anschluss (4) des Schaltelements (2) befindet sich ein Messknoten (10) an dem ein Messanschluss (11) zum Abgriff einer betätigungsabhängigen Spannung $U_1$ vorgesehen ist.

Am Gegenkontakt (5) ist ein zweiter Anschluss (6) des Schaltelements (2) vorgesehen. Dieser zweite Anschluss (6) verbindet den Gegenkontakt (5) mit einem ersten Spannungsversorgungsanschluss (7). Der erste Spannungsversorgungsanschluss (7) ist in diesem Beispiel mit dem Referenzpotential der erfindungsgemäßen Eingabevorrichtung (1) verbunden, was hier die Masse bzw. das Massepotential ist. Des Weiteren weist das Schaltelement (2) einen dritten Anschluss (12) auf, welcher am Schaltkontakt (3) auf der gegenüberliegenden Seite des ersten Anschlusses (4) vorgesehen ist. Zwischen dem zweiten und dritten Anschluss (6, 12) ist ein zweiter Widerstand (13) geschaltet.

Im unbetätigten Zustand der erfindungsgemäßen Eingabevorrichtung (1) bzw. bei Nichtbetätigen des Schaltelements (2) ist am Messanschluss (11) eine betätigungsabhängige Spannung $U_1$ abgreifbar, die aus dem Spannungsteilerverhältnis zwischen dem ersten Widerstand (9) und dem zweiten Widerstand (13) resultiert. Dabei gilt der folgende Zusammenhang mit $U_1$ als betätigungsabhängige Spannung, $U_B$ als positive Betriebsspannung, $R_1$ als ersten Widerstand und $R_2$ als zweiten Widerstand:

$$U_1 = U_B * \frac{R_2}{R_2 + R_1}$$

Diese Spannung $U_1$ ist, wie sich zeigen wird, eindeutig unterscheidbar von den Spannungen der übrigen Zustände der erfindungsgemäßen Eingabevorrichtung (1), so dass die Nichtbetätigung der erfindungsgemäßen Eingabevorrichtung (1) eindeutig erkennbar ist.

So zeigt die Fig. 1b die erfindungsgemäße Eingabevorrichtung (1) gemäß dem Ausführungsbeispiel nach Fig. 1a entspricht, wobei sich nun die erfindungsgemäße Eingabevorrichtung in einem betätigten Zustand befindet. Das Schaltelement (2) wurde betätigt, indem eine Kraft F auf den Schaltkontakt (3) einwirkt. Durch die Einwirkung der Kraft F und der Ausführung des Schaltelements (2) mit einem dom- oder kuppelförmigen Schaltkontakt (3), ist der Schaltkontakt (3) verformt und ist mit dem Gegenkontakt (5) elektrisch verbunden bzw. kontaktiert. Durch die entsprechende Verformung des Schaltkontaktes (3) wird zusätzlich eine haptische Rückmeldung bei dem Betätiger erzeugt.

Durch die Betätigung ist der zweite Widerstand (13) zwischen dem zweiten Anschluss (6) und dem dritten Anschluss (12) des Schaltelements (2) überbrückt bzw. kurzgeschlossen, und der Messknoten (10) ist direkt mit dem Gegenkontakt (5) bzw. mit dem zweiten Anschluss (6) des Schaltelements (2) verbunden. Der zweite Anschluss (6) ist in diesem Ausführungsbeispiel mit dem ersten Spannungsversorgungsanschluss (7) verbunden, welcher auf dem Referenzpotential der erfindungsgemäßen Eingabevorrichtung (1) liegt, was hier die Masse bzw. das Massepotential ist. Somit liegt auch der Messknoten (10) auf Masse, so dass am Messanschluss (11) folgende betätigungsabhängige Spannung $U_1$ messbar ist:

$$U_1 = Masse$$

Auch diese Spannung $U_1$ ist eindeutig unterscheidbar von den Spannungen der übrigen Zustände der erfindungsgemäßen Eingabevorrichtung (1). Damit ist die Betätigung der erfindungsgemäßen Eingabevorrichtung (1) eindeutig erkennbar.

Die Fig. 1c zeigt die erfindungsgemäße Eingabevorrichtung (1) gemäß dem Ausführungsbeispiel nach Fig. 1a, wobei nun ein Fehlerfall am Schaltkontakt (3) des Schaltelements (2) aufgetreten ist. Die erfindungsgemäße Eingabevorrichtung (1) befindet sich demnach in einem Fehlerzustand. Der Fehlerfall umfasst einen Bruch (19) des Schaltkontaktes (3) zwischen dem ersten Anschluss (4) und dem dritten Anschluss (12) des Schaltelements (2).

Dadurch ist die Verbindung des ersten Anschlusses (4) zu den übrigen Anschlüssen (6, 12) des Schaltelements (2) unterbrochen, so dass der Messknoten (10) stets auf dem Potential des zweiten Spannungsversorgungsanschlusses (8) liegt, was hier die Betriebsspannung $U_B$ ist. Somit ist am Messanschluss (11) folgende Fehlerspannung $U_2$ messbar:

$$U_2 = U_B$$

Auch diese Spannung $U_2$ ist eindeutig unterscheidbar von den Spannungen der übrigen Zustände der erfindungsgemäßen Eingabevorrichtung (1). Auch damit ist der Fehlerfall der erfindungsgemäßen Eingabevorrichtung (1) eindeutig erkennbar.

Die Fig. 2a zeigt ein weiteres Ausführungsbeispiel der erfindungsgemäßen Eingabevorrichtung (1). Dieses Beispiel basiert im Wesentlichen auf dem Ausführungsbeispiel gemäß Fig. 1a, wobei nun der erste Widerstand (9) zwischen dem erstem Spannungsversorgungsanschluss (7) und zweiten Anschluss (6) des Schaltelements (2) angeordnet ist, anstelle zwischen dem zweitem Spannungsversorgungsanschluss (8) und dem erstem Anschluss (4) des Schaltelements (2). Entsprechend ist nun der Messknoten (10) mit dem Messanschluss (11) zwischen dem zweiten Anschluss (6) des Schaltelements (2) und dem ersten Widerstand (9) vorgesehen. Des Weiteren ist nun der erste Anschluss (4) des Schaltelements (2) direkt mit dem zweiten Spannungsversorgungsanschluss (8) verbunden. Der erste Spannungsversorgungsanschluss (7) ist in diesem Beispiel mit dem Referenzpotential, hier die Masse, der erfindungsgemäßen Eingabevorrichtung (1) verbunden. Der zweite Spannungsversorgungsanschluss (8) ist mit einer positiven Betriebsspannung $U_B$ verbunden.

Im unbetätigten Zustand der erfindungsgemäßen Eingabevorrichtung (1) gemäß diesem zweiten Ausführungsbeispiel bzw. bei Nichtbetätigen des Schaltelements (2), ist am Messanschluss (11) eine betätigungsabhängige Spannung $U_1$ abgreifbar, die aus dem Spannungsteilerverhältnis zwischen dem ersten Widerstand (9) und dem zweiten Widerstand (13) resultiert. Dabei gilt der folgende Zusammenhang mit $U_1$ als betätigungsabhängige Spannung, $U_B$ als positive Betriebsspannung, $R_1$ als ersten Widerstand und $R_2$ als zweiten Widerstand:

$$U_1 = U_B * \frac{R_1}{R_2 + R_1}$$

Diese Spannung $U_1$ ist eindeutig unterscheidbar von den Spannungen der übrigen Zustände der erfindungsgemäßen Eingabevorrichtung (1) gemäß diesem zweiten Ausführungsbeispiel. Damit ist die Nichtbetätigung der erfindungsgemäßen Eingabevorrichtung (1) eindeutig erkennbar.

Die Fig. 2b zeigt die erfindungsgemäße Eingabevorrichtung (1) gemäß dem zweiten Ausführungsbeispiel, wobei diese sich jetzt in einem betätigten Zustand befindet. Das Schaltelement (2) wurde betätigt, indem eine Kraft F auf den Schaltkontakt (3) einwirkt. Durch die Einwirkung der Kraft F und der Ausführung des Schaltelements (2) mit einem dom- oder kuppelförmigen Schaltkontakt (3), ist der Schaltkontakt (3) verformt und ist mit dem Gegenkontakt (5) elektrisch verbunden bzw. kontaktiert.

Dadurch ist der zweite Widerstand (13) zwischen dem zweiten Anschluss (6) und dem dritten Anschluss (12) des Schaltelements (2) überbrückt bzw. kurzgeschlossen und der Messknoten (10) ist direkt mit dem ersten Anschluss (4) des Schaltelements (2) verbunden. Da der erste Anschluss (4) mit dem zweiten Spannungsversorgungsanschluss (8) verbunden ist, welcher auf dem positiven Betriebsspannungspotential liegt, liegt dadurch auch der Messknoten (10) auf dem positiven Betriebsspannungspotential, so dass am Messanschluss (11) folgende betätigungsabhängige Spannung $U_1$ messbar ist:

$$U_1 = U_B$$

Auch diese Spannung $U_1$ ist eindeutig unterscheidbar von den Spannungen der übrigen Zustände der erfindungsgemäßen Eingabevorrichtung (1) gemäß diesem zweiten Ausführungsbeispiel. Auch damit ist die Betätigung der erfindungsgemäßen Eingabevorrichtung (1) eindeutig erkennbar.

Die Fig. 2c zeigt die erfindungsgemäße Eingabevorrichtung (1) gemäß dem zweiten Ausführungsbeispiel nach Fig. 2a, wobei nun ein Fehlerfall am Schaltkontakt (3) des Schaltelements (2) aufgetreten ist. Die erfindungsgemäße Eingabevorrichtung (1) befindet sich demnach in einem Fehlzustand. Der Fehlerfall umfasst einen Bruch (19) des Schaltkontaktes (3) zwischen dem ersten Anschluss (4) und dem dritten Anschluss (12) des Schaltelements (2).

Dadurch ist die Verbindung des ersten Anschlusses (4) zu den übrigen Anschlüssen (6, 12) des Schaltelements (2) unterbrochen, so dass der Messknoten (10) nun auf dem Potential des ersten Spannungsversorgungsanschlusses (7) liegt, was hier dem Referenzpotential entspricht. Somit ist am Messanschluss (11) folgende Fehlerspannung $U_2$ messbar:

$$U_2 = Masse$$

Auch diese Spannung $U_2$ ist eindeutig unterscheidbar von den Spannungen der übrigen Zustände der erfindungsgemäßen Eingabevorrichtung (1) gemäß dem zweiten Ausführungsbeispiel. Damit ist also auch der Fehlerfall der erfindungsgemäßen Eingabevorrichtung (1) eindeutig erkennbar.

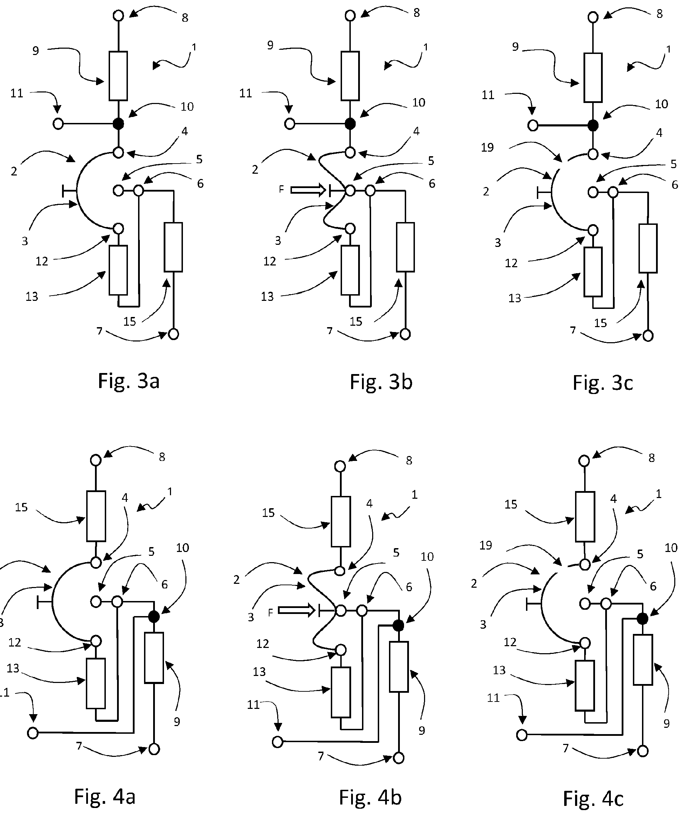

Die Fig. 3a zeigt ein drittes Ausführungsbeispiel der erfindungsgemäßen Eingabevorrichtung (1). Dieses Beispiel basiert im Wesentlichen auf dem Ausführungsbeispiel gemäß Fig. 1a, wobei nun ein dritter Widerstand (15) vorgesehen ist. Der dritte Widerstand (15) ist zwischen dem zweiten Anschluss (6) des Schaltelements (2) und dem ersten Spannungsversorgungsanschluss (7) geschaltet bzw. angeordnet. Der erste Spannungsversorgungsanschluss (7) ist in diesem Beispiel ebenfalls mit dem Referenzpotential, hier die Masse, der erfindungsgemäßen Eingabevorrichtung (1) verbunden, und der zweite Spannungsversorgungsanschluss (8) ist mit einer positiven Betriebsspannung $U_B$ verbunden.

Im unbetätigten Zustand der erfindungsgemäßen Eingabevorrichtung (1) gemäß diesem dritten Ausführungsbeispiel bzw. bei Nichtbetätigen des Schaltelements (2), ist am Messanschluss (11) eine betätigungsabhängige Spannung $U_1$ abgreifbar, die aus dem Spannungsteilerverhältnis zwischen dem ersten Widerstand (9), dem zweiten Widerstand (13) und dem dritten Widerstand (15) resultiert. Dabei gilt der folgende Zusammenhang mit $U_1$ als betätigungsabhängige Spannung, $U_B$ als positive Betriebsspannung, $R_1$ als ersten Widerstand, $R_2$ als zweiten Widerstand und $R_3$ als dritten Widerstand:

$$U_1 = U_B * \frac{R_2 + R_3}{R_2 + R_1 + R_3}$$

Diese Spannung $U_1$ ist eindeutig unterscheidbar von den Spannungen der übrigen Zustände der erfindungsgemäßen Eingabevorrichtung (1) gemäß dem dritten Ausführungsbeispiel und damit die Nichtbetätigung der erfindungsgemäßen Eingabevorrichtung (1) eindeutig erkennbar.

Die Fig. 3b zeigt die erfindungsgemäße Eingabevorrichtung (1) gemäß dem dritten Ausführungsbeispiel, wobei diese sich jetzt in einem betätigten Zustand befindet. Das Schaltelement (2) wurde betätigt, indem eine Kraft F auf den Schaltkontakt (3) einwirkt. Durch die Einwirkung der Kraft F und der Ausführung des Schaltelements (2) mit einem dom- oder kuppelförmigen Schaltkontakt (3), ist der Schaltkontakt (3) verformt und ist mit dem Gegenkontakt (5) elektrisch verbunden bzw. kontaktiert.

Dadurch ist der zweite Widerstand (13) zwischen dem zweiten Anschluss (6) und dem dritten Anschluss (12) des Schaltelements (2) überbrückt bzw. kurzgeschlossen und der Messknoten (10) ist direkt mit dem zweiten Anschluss (4) des Schaltelements (2) verbunden. Somit liegt der Messknoten (10) nun zwischen dem ersten Widerstand (9) und dem dritten Widerstand (15), so dass am Messanschluss (11) folgende betätigungsabhängige Spannung $U_1$ messbar ist:

$$U_1 = U_B * \frac{R_3}{R_1 + R_3}$$

Auch diese Spannung $U_1$ ist eindeutig unterscheidbar von den übrigen Zuständen der erfindungsgemäßen Eingabevorrichtung (1) gemäß diesem Ausführungsbeispiel und damit die Betätigung der erfindungsgemäßen Eingabevorrichtung (1) eindeutig erkennbar.

Die Fig. 3c zeigt die erfindungsgemäße Eingabevorrichtung (1) gemäß dem dritten Ausführungsbeispiel nach Fig. 3a, wobei nun ein Fehlerfall am Schaltkontakt (3) des Schaltelements (2) aufgetreten ist. Die erfindungsgemäße Eingabevorrichtung (1) befindet sich demnach in einem Fehlerzustand. Der Fehlerfall umfasst einen Bruch (19) des Schaltkontaktes (3) zwischen dem ersten Anschluss (4) und dem dritten Anschluss (12) des Schaltelements (2).

Dadurch ist die Verbindung des ersten Anschlusses (4) zu den übrigen Anschlüssen (6, 12) des Schaltelements (2) unterbrochen, so dass der Messknoten (10) stets auf dem Potential des zweiten Spannungsversorgungsanschlusses (8) liegt, was hier der positiven Betriebsspannung entspricht. Somit ist am Messanschluss (11) folgende Fehlerspannung $U_2$ messbar:

$$U_2 = U_B$$

Auch diese Spannung $U_2$ ist eindeutig unterscheidbar von den Spannungen der übrigen Zustände der erfindungsgemäßen Eingabevorrichtung (1) gemäß dem dritten Ausführungsbeispiel. Damit ist also auch der Fehlerfall der erfindungsgemäßen Eingabevorrichtung (1) eindeutig erkennbar.

Die Fig. 4a zeigt ein viertes Ausführungsbeispiel der erfindungsgemäßen Eingabevorrichtung (1). Dieses Beispiel basiert im Wesentlichen auf dem Ausführungsbeispiel gemäß Fig. 2a, wobei nun ein dritter Widerstand (15) vorgesehen ist. Der dritte Widerstand (15) ist zwischen dem ersten Anschluss (4) des Schaltelements (2) und dem zweiten Spannungsversorgungsanschluss (8) geschaltet bzw. angeordnet. Der erste Spannungsversorgungsanschluss (7) ist in diesem Beispiel ebenfalls mit dem Referenzpotential, hier die Masse, der erfindungsgemäßen Eingabevorrichtung (1) verbunden, und der zweite Spannungsversorgungsanschluss (8) ist mit einer positiven Betriebsspannung $U_B$ verbunden.

Im unbetätigten Zustand der erfindungsgemäßen Eingabevorrichtung (1) gemäß diesem vierten Ausführungsbeispiel bzw. bei Nichtbetätigen des Schaltelements (2), ist am Messanschluss (11) eine betätigungsabhängige Spannung $U_1$ abgreifbar, die aus dem Spannungsteilerverhältnis zwischen dem ersten Widerstand (9) dem zweiten Widerstand (13) und dem dritten Widerstand (15) resultiert. Dabei gilt der folgende Zusammenhang mit $U_1$ als betätigungsabhängige Spannung, $U_B$ als positive Betriebsspannung, $R_1$ als ersten Widerstand $R_2$ als zweiten Widerstand und $R_3$ als dritten Widerstand:

$$U_1 = U_B * \frac{R_1}{R_2 + R_1 + R_3}$$

Diese Spannung $U_1$ ist eindeutig unterscheidbar von den Spannungen der übrigen Zustände der erfindungsgemäßen Eingabevorrichtung (1) gemäß diesem Ausführungsbeispiel und damit die Nichtbetätigung der erfindungsgemäßen Eingabevorrichtung (1) eindeutig erkennbar.

Die Fig. 4b zeigt die erfindungsgemäße Eingabevorrichtung (1) gemäß dem vierten Ausführungsbeispiel, wobei diese sich jetzt in einem betätigten Zustand befindet. Das Schaltelement (2) wurde betätigt, indem eine Kraft F auf den Schaltkontakt (3) einwirkt. Durch die Einwirkung der Kraft F und der Ausführung des Schaltelements (2) mit einem dom- oder kuppelförmigen Schaltkontakt (3), ist der Schaltkontakt (3) verformt und ist mit dem Gegenkontakt (5) elektrisch verbunden bzw. kontaktiert.

Dadurch ist der zweite Widerstand (13) zwischen dem zweiten Anschluss (6) und dem dritten Anschluss (12) des Schaltelements (2) überbrückt bzw. kurzgeschlossen und der Messknoten (10) ist direkt mit dem ersten Anschluss (4) des Schaltelements (2) verbunden. Somit liegt der Messknoten (10) nun zwischen dem ersten Widerstand (9) und dem dritten Widerstand (15), so dass am Messanschluss (11) folgende betätigungsabhängige Spannung $U_1$ messbar ist:

$$U_1 = U_B * \frac{R_1}{R_1 + R_3}$$

Auch diese Spannung $U_1$ ist eindeutig unterscheidbar von den Spannungen der übrigen Zustände der erfindungsgemäßen Eingabevorrichtung (1) gemäß diesem Ausführungsbeispiel und damit die Betätigung der erfindungsgemäßen Eingabevorrichtung (1) eindeutig erkennbar.

Die Fig. 4c zeigt die erfindungsgemäße Eingabevorrichtung (1) gemäß dem vierten Ausführungsbeispiel nach Fig. 4a, wobei nun ein Fehlerfall am Schaltkontakt (3) des Schaltelements (2) aufgetreten ist. Die erfindungsgemäße Eingabevorrichtung (1) befindet sich demnach in einem Fehlerzustand. Der Fehlerfall umfasst einen Bruch (19) des Schaltkontaktes (3) zwischen dem ersten Anschluss (4) und dem dritten Anschluss (12) des Schaltelements (2).

Dadurch ist die Verbindung des ersten Anschlusses (4) zu den übrigen Anschlüssen (6, 12) des Schaltelements (2) unterbrochen, so dass der Messknoten (10) stets auf dem Potential des ersten Spannungsversorgungsanschlusses (7) liegt, was hier dem Referenzpotential entspricht. Somit ist am Messanschluss (11) folgende Fehlerspannung $U_2$ messbar:

$$U_2 = Masse$$

Auch diese Spannung $U_2$ ist eindeutig unterscheidbar von den Spannungen der übrigen Zustände der erfindungsgemäßen Eingabevorrichtung (1) gemäß dem vierten Ausführungsbeispiel. Damit ist also auch der Fehlerfall der erfindungsgemäßen Eingabevorrichtung (1) eindeutig erkennbar.

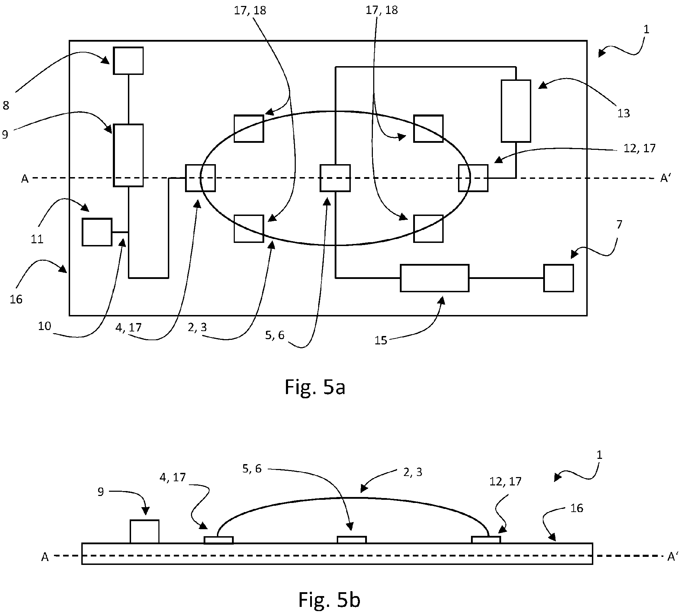

Fig. 5a zeigt schematisch ein fünftes Ausführungsbeispiel der erfindungsgemäßen Eingabevorrichtung (1), wobei hier die Schaltung der erfindungsgemäßen Eingabevorrichtung (1) auf einer Leiterplatte (16) gezeigt ist. Die Schaltung entspricht dabei im Wesentlichen dem Ausführungsbeispiel gemäß Fig. 3a, wobei die Bezugszeichen für die jeweiligen Komponenten identisch gewählt sind. Auf eine Wiederholung der jeweiligen Komponenten wird verzichtet, da diese vollkommen analog zum Ausführungsbeispiel gemäß Fig. 3a sind.

Der Schaltkontakt (3) ist dom- oder kuppelförmig ausgeführt und auf der Leiterplatte (16) angeordnet. Dazu ist das Schaltelement (2) mit zwei Anschlüssen (4, 12) versehen, welche in Form von Lötpunkten (17) auf der Leiterplatte (16) ausgeführt sind. Außerdem sind weitere Lötpunkte (17) auf der Leiterplatte (16) als Auflagepunkte (18) für den Schaltkontakt (3) vorgesehen zur Befestigung des Schaltkontakts (2) auf der Leiterplatte (16). Dadurch kann sich der entsprechende Schaltkontakt (3) bei Betätigung verformen unter Erzeugung einer haptischen Rückmeldung an den Betätiger. Dabei wird ein Kontakt zwischen dem Schaltkontakt (3) und dem Gegenkontakt (5) geschlossen, welcher zentral unterhalb des Schaltkontaktes (3) angeordnet ist.

Die Anordnung der Kontakte wird noch einmal in der Fig. 5b verdeutlicht, welche eine Schnittansicht durch die Schnittachse A-A' der Fig. 5a ist. Hier ist die dom- oder kuppelförmige Form des Schalkontaktes (3) verdeutlicht, wobei der Schalkontakt (3) an den Lötpunkten (17) befestigt ist, welche hier zusätzlich als Anschlüsse (4, 12) des Schaltelements (2) dienen. Der Gegenkontakt (5) ist mittig unter dem dom- oder kuppelförmigen Schaltkontakt (3) angeordnet. Die Fig. 5b zeig die erfindungsgemäße Eingabevorrichtung (1) gemäß dem fünften Ausführungsbeispiel im unbetätigten Zustand.

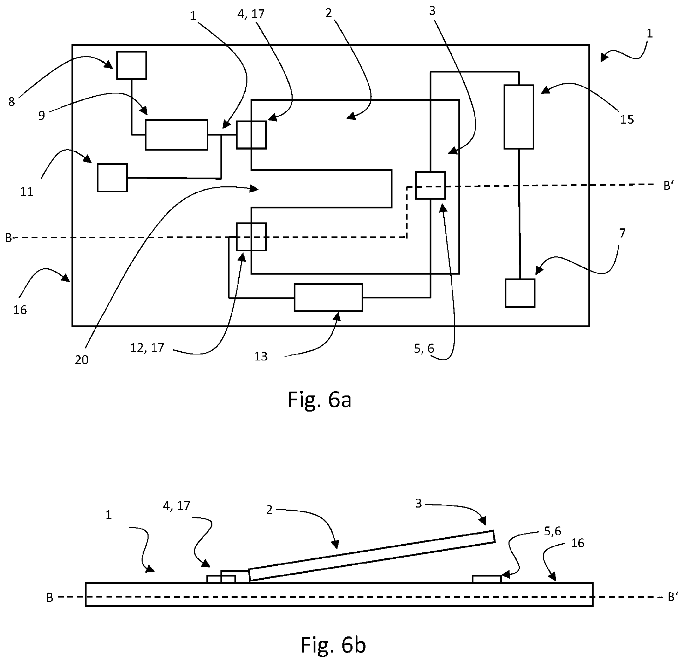

Fig. 6a zeigt schematisch ein sechstes Ausführungsbeispiel der erfindungsgemäßen Eingabevorrichtung (1), wobei hier die Schaltung der erfindungsgemäßen Eingabevorrichtung (1) auf einer Leiterplatte (16) gezeigt ist. Die Schaltung entspricht dabei im Wesentlichen dem Ausführungsbeispiel gemäß Fig. 3a, wobei die Bezugszeichen für die jeweiligen Komponenten identisch gewählt sind. Auf eine Wiederholung der jeweiligen Komponenten wird verzichtet, da diese vollkommen analog zum Ausführungsbeispiel gemäß Fig. 3a sind.

Der Schaltkontakt (2) ist flächig ausgeführt und auf der Leiterplatte (16) angeordnet. Dazu ist das Schaltelement (2) mit zwei Anschlüssen (4, 12) versehen, welche in Form von Lötpunkten (17) auf der Leiterplatte (16) ausgeführt sind. Der Schaltkontakt (3) des Schaltelements (2) ist federnd ausgeführt, um im Sinne eines Tasters den Kontakt zwischen Schaltkontakt (3) und Gegenkontakt (5) zu schließen. Der flächige Schaltkontakt (3) weist des Weiteren einen Schlitz (20) auf, so dass der Schaltkontakt (3) zwei voneinander getrennte Anschlussbereiche aufweist, an denen der erste Anschluss (4) und der dritte Anschluss (12) vorgesehen sind.

Die Anordnung der Kontakte wird noch einmal in der Fig. 6b verdeutlicht, welche eine Schnittansicht durch die Schnittachse B-B' der Fig. 6a ist. Hier ist die flächige Form des Schalkontaktes (3) verdeutlicht, wobei der Schalkontakt (3) an dem Lötpunkt (17) befestigt ist, welcher hier zusätzlich als Anschluss (4) des Schaltelements (2) dient. Der Gegenkontakt (5) ist in der Nähe des Endbereichs des Schaltkontaktes (3) auf der Leiterplatte (16) angeordnet, so dass bei Betätigung sich der Schaltkontakt (3) in Richtung des Gegenkontaktes (5) bewegt bis der Kontakt geschlossen wird. Die Fig. 6b zeigt die erfindungsgemäße Eingabevorrichtung (1) gemäß dem sechsten Ausführungsbeispiel im unbetätigten Zustand.

## Patentansprüche

1. Eingabevorrichtung (1) für sicherheitsrelevante Funktionen eines Kraftfahrzeuges mit einem Schaltelement (2), welches einen Schaltkontakt (3) mit einem ersten Anschluss (4) sowie einen Gegenkontakt (5) mit einem zweiten Anschluss (6) aufweist, wobei bei Betätigung der Eingabevorrichtung (1) der Schaltkontakt (3) mit dem Gegenkontakt (5) kontaktierbar ist, mit einem ersten Widerstand (9), mit einem ersten und zweiten Spannungsversorgungsanschluss (7, 8) über die eine Betriebsspannung für die Eingabevorrichtung (1) bereitstellbar ist, wobei der erste Spannungsversorgungsanschluss (7) mit einem der Anschlüsse (4, 6) des Schaltelements (2) verbunden ist und der zweite Spannungsversorgungsanschluss (8) über den ersten Widerstand (9) mit dem jeweils anderen Anschluss (4, 6) des Schaltelements (2) verbunden ist, mit einem Messknoten (10), welcher zwischen dem erstem Widerstand (9) und dem jeweiligen Anschluss (4, 6) des Schaltelements (2) vorgesehen ist und welcher mit einem Messanschluss (11) verbunden ist, so dass eine betätigungsabhängige Spannung (U1) über den Messanschluss (11) erfassbar ist, welche von der Betätigung der Eingabevorrichtung (1) abhängig ist,

**dadurch gekennzeichnet, dass**

das Schaltelement (2) einen dritten Anschluss (12) aufweist, welcher mit dem Schaltkontakt (3) verbunden ist, wobei ein zweiter Widerstand (13) vorgesehen ist, welcher mit dem zweiten und dritten Anschluss (6, 12) des Schaltelements (2) verbunden ist und zwischen dem zweiten und dritten Anschluss (6, 12) geschaltet ist, so dass bei einem Fehler des Schaltkontakts (2), welcher die elektrische Verbindung zwischen dem ersten und dritten Anschluss beeinflusst (4, 12), vorzugsweise bei einem Bruch (19) des Schaltkontaktes (3), am Messknoten (10) über den Messanschluss (11) eine Fehlerspannung (U2) erfassbar ist, welche von der betätigungsabhängigen Spannung (U1) unterscheidbar ist.

2. Eingabevorrichtung (1) nach Anspruch 1, wobei eine Auswerteschaltung (14) vorgesehen ist, welche über den Messanschluss (11) die Spannung am Messknoten (10) erfasst und dadurch eine Betätigung der Eingabevorrichtung (1) und/oder einen Fehler des Schaltkontaktes (3) erkennbar ist.

3. Eingabevorrichtung (1) nach einem der Ansprüche 1 oder 2, wobei der Schaltkontakt (3) dom- oder kuppelförmig ausgebildet ist und vorzugsweise der erste und dritte Anschluss (4, 12) an sich gegenüberliegenden Bereichen des dom- oder kuppelförmigen Schaltkontaktes (3) vorgesehen sind.

4. Eingabevorrichtung (1) nach einem der Ansprüche 1 oder 2, wobei der Schaltkontakt (3) flächig ausgebildet ist und vorzugsweise der erste und dritte Anschluss (4, 12) benachbart an einer Kante oder an sich gegenüberliegenden Bereichen des flächigen Schaltkontaktes (3) vorgesehen sind.

5. Eingabevorrichtung (1) nach einem der vorangehenden Ansprüche, wobei ein dritter Widerstand (15) zwischen dem ersten Spannungsversorgungsanschluss (7) und dem jeweiligen Anschluss (4, 6) des Schaltelements (2) vorgesehen ist, so dass der jeweilige Anschluss (4, 6) des Schaltelements (2) über den dritten Widerstand (15) mit dem ersten Spannungsversorgungsanschluss verbunden ist.

6. Eingabevorrichtung (1) nach einem der vorangehenden Ansprüche, wobei der zweite Spannungsversorgungsanschluss (8) mit einer positiven Betriebsspannung verbunden ist und der erste Spannungsversorgungsanschluss (7) mit einem Bezugspotential der Eingabevorrichtung (1), vorzugsweise Masse, verbunden ist.

7. Eingabevorrichtung (1) nach einem der vorangehenden Ansprüche, wobei im unbetätigten Zustand der Eingabevorrichtung (1) am Messknoten (10) eine betätigungsabhängige Spannung (U1) erfassbar ist, welche aus dem Spannungsteilerverhältnis zwischen erstem Widerstand (9) und zweitem Widerstand (13) und vorzugsweise drittem Widerstand (15) resultiert.

8. Eingabevorrichtung (1) nach einem der vorangehenden Ansprüche, wobei im betätigten Zustand der Eingabevorrichtung (1) am Messknoten (10) eine betätigungsabhängige Spannung (U1) erfassbar ist, welche der Spannung bzw. dem Potential des ersten Spannungsversorgungsanschlusses (7) entspricht oder aus dem Spannungsteilerverhältnis zwischen erstem Widerstand (9) und drittem Widerstand (15) resultiert.

9. Eingabevorrichtung (1) nach einem der vorangehenden Ansprüche, wobei bei einem Fehler des Schaltkontaktes (3), vorzugsweise bei einem Bruch (19) des Schaltkontaktes (3), am Messknoten (10) eine Fehlerspannung (U2) erfassbar ist, welche der Spannung bzw. dem Potential des zweiten Spannungsversorgungsanschlusses (8) entspricht.

10. Eingabevorrichtung (1) nach einem der vorangehenden Ansprüche, wobei die Auswerteeinheit (14) einen Analog-Digital-Wandler umfasst, so dass die erfasste Spannung in einen digitalen Wert wandelbar und digital verarbeitbar ist.

11. Eingabevorrichtung (1) nach einem der vorangehenden Ansprüche, wobei bei Betätigung der Eingabevorrichtung (1) die Kontaktierung zwischen Schaltkontakt (3) und Gegenkontakt (5) galvanisch bzw. elektrisch leitend ist.

12. Eingabevorrichtung (1) nach einem der Ansprüche 1 bis 10, wobei bei Betätigung der Eingabevorrichtung (1) die Kontaktierung zwischen Schaltkontakt (3) und Gegenkontakt (5) resistiv oder kapazitiv ist.

13. Eingabevorrichtung (1) nach einem der vorangehenden Ansprüche, wobei das Schaltelement (2) und die Widerstände (9, 13, 15) auf einer Leiterplatte (16) angeordnet sind und vorzugsweise zumindest der erste und dritte Anschluss (4, 12) als Lötpunkte (17) auf der Leiterplatte (16) ausgeführt sind.

14. Eingabevorrichtung (1) nach Anspruch 13, wobei der dom- oder kuppelförmige Schaltkontakt (3) mit den Lötpunkten (17) für den ersten und dritten Anschluss (4, 12) verlötet ist und der Gegenkontakt (5) zwischen diesen beiden Lötpunkten (17) auf der Leiterplatte (16) vorgesehen ist.

15. Eingabevorrichtung (1) nach Anspruch 14, wobei auf der Leiterplatte (16) weitere Auflagepunkte (18) für den dom- oder kuppelförmigen Schaltkontakt (3) vorgesehen sind, welche vorzugsweise als Lötpunkte (17) ausgeführt sind.

**Claims**

1. Input device (1) for safety-relevant functions of a motor vehicle, having a switching element (2), which has a switching contact (3) with a first connection (4) and a mating contact (5) with a second connection (6), wherein the switching contact (3) is able to make contact with the mating contact (5) when the input device (1) is actuated, having a first resistor (9), with a first and a second voltage supply connection (7, 8) via which an operating voltage for the input device (1) is able to be provided, wherein the first voltage supply connection (7) is connected to one of the connections (4, 6) of the switching element (2) and the second voltage supply connection (8) is connected via the first resistor (9) to the respective other connection (4, 6) of the switching element (2), having a measuring node (10) that is provided between the first resistor (9) and the respective connection (4, 6) of the switching element (2) and that is connected to a measuring connection (11), such that an actuation-dependent voltage (U1), which is dependent on the actuation of the input device (1), is able to be recorded via the measuring connection (11), **characterized in that** the switching element (2) has a third connection (12) that is connected to the switching contact (3), wherein a second resistor (13) is provided, which is connected to the second and third connections (6, 12) of the switching element (2) and is connected between the second and third connections (6, 12) such that, in the event of a fault of the switching contact (2), which affects the electrical connection between the first and third connections (4, 12), preferably in the event of a break (19) of the switching contact (3), a fault voltage (U2) is able to be recorded at the measuring node (10) via the measuring connection (11) and is able to be distinguished from the actuation-dependent voltage (U1).

2. Input device (1) according to Claim 1, wherein an evaluation circuit (14) is provided, which records the voltage at the measuring node (10) via the measuring connection (11) and as a result is able to detect an actuation of the input device (1) and/or a fault of the switching contact (3).

3. Input device (1) according to either of Claims 1 and 2, wherein the switching contact (3) is rounded or dome-shaped and preferably the first and third connections (4, 12) are provided in opposite regions of the rounded or dome-shaped switching contact (3).

4. Input device (1) according to either of Claims 1 and 2, wherein the switching contact (3) is of planar design and preferably the first and third connections (4, 12) are provided adjacent to an edge or in opposite regions of the planar switching contact (3).

5. Input device (1) according to one of the preceding claims, wherein a third resistor (15) is provided between the first voltage supply connection (7) and the respective connection (4, 6) of the switching element (2) such that the respective connection (4, 6) of the switching element (2) is connected to the first voltage supply connection via the third resistor (15).

6. Input device (1) according to one of the preceding claims, wherein the second voltage supply connection (8) is connected to a positive operating voltage and the first voltage supply connection (7) is connected to a reference potential of the input device (1), preferably ground.

7. Input device (1) according to one of the preceding claims, wherein, in the unactuated state of the input device (1), an actuation-dependent voltage (U1), which results from the voltage divider ratio between the first resistor (9) and the second resistor (13) and preferably the third resistor (15) is able to be recorded at the measuring node (10).

8. Input device (1) according to one of the preceding claims, wherein, in the actuated state of the input device (1), an actuation-dependent voltage (U1), which corresponds to the voltage or the potential of the first voltage supply connection (7) or results from the voltage divider ratio between the first resistor (9) and the third resistor (15), is able to be recorded at the measuring node (10).

9. Input device (1) according to one of the preceding claims, wherein, in the event of a fault of the switching contact (3), preferably in the event of a break (19) of the switching contact (3), a fault voltage (U2), which corresponds to the voltage or the potential of the second voltage supply connection (8) is able to be recorded at the measuring node (10).

10. Input device (1) according to one of the preceding claims, wherein the evaluation unit (14) comprises an analogue-to-digital converter such that the recorded voltage is able to be converted into a digital value and digitally processed.

11. Input device (1) according to one of the preceding claims, wherein, when the input device (1) is actuated, the contact between the switching contact (3) and the mating contact (5) is galvanically or electrically conductive.

12. Input device (1) according to one of Claims 1 to 10, wherein, when the input device (1) is actuated, the contact between the switching contact (3) and the mating contact (5) is resistive or capacitive.

13. Input device (1) according to one of the preceding claims, wherein the switching element (2) and the resistors (9, 13, 15) are arranged on a printed circuit board (16) and preferably at least the first and third connections (4, 12) are embodied as solder points (17) on the printed circuit board (16).

14. Input device (1) according to Claim 13, wherein the rounded or dome-shaped switching contact (3) is soldered to the solder points (17) for the first and third connections (4, 12) and the mating contact (5) is provided between these two solder points (17) on the printed circuit board (16).

15. Input device (1) according to Claim 14, wherein further support points (18) for the rounded or dome-shaped switching contact (3) are provided on the printed circuit board (16) and are preferably embodied as solder points (17).

**Revendications**

1. Dispositif d'entrée (1) destiné à des fonctions de sécurité d'un véhicule à moteur, comprenant un élément de commutation (2), qui comporte un contact de commutation (3) pourvu d'une première borne de connexion (4) ainsi qu'un contact homologue (5) pourvu d'une deuxième borne de connexion (6), dans lequel, lors de l'actionnement du dispositif d'entrée (1), le contact de commutation (3) peut être mis en contact avec le contact homologue (5), comprenant une première résistance (9), des première et deuxième bornes d'alimentation en tension (7, 8) par l'intermédiaire desquelles une tension de fonctionnement destinée au dispositif d'entrée (1) peut être fournie, la première borne d'alimentation en tension (7) étant raccordée à l'une des bornes de connexion (4, 6) de l'élément de commutation (2) et la deuxième borne d'alimentation en tension (8) étant raccordée, par l'intermédiaire de la première résistance (9), à l'autre borne de connexion (4, 6) respective de l'élément de commutation (2), comprenant un nœud de mesure (10), qui est prévu entre la première résistance (9) et la borne de connexion (4, 6) respective de l'élément de commutation (2) et qui est raccordé à une borne de mesure (11), de sorte qu'une tension fonction de l'actionnement (U1), qui dépend de l'actionnement du dispositif d'entrée (1), peut être détectée par l'intermédiaire de la borne de mesure (11),

**caractérisé en ce que**
l'élément de commutation (2) comporte une troisième borne de connexion (12), qui est raccordée au contact de commutation (3), dans lequel il est prévu une deuxième résistance (13) qui est raccordée aux deuxième et troisième bornes de connexion (6, 12) de l'élément de commutation (2) et est commutée entre les deuxième et troisième bornes de connexion (6, 12), de sorte qu'en cas de défaut de l'élément de commutation (2), qui a une influence sur la connexion électrique entre les première et troisième bornes de connexion (4, 12), de préférence en cas de rupture (19) du contact de commutation (3), une tension de défaut (U2), qui peut être distinguée de la tension fonction de l'actionnement (U1), peut être détectée au niveau du nœud de mesure (10) par l'intermédiaire de la borne de mesure (11).

2. Dispositif d'entrée (1) selon la revendication 1, dans lequel il est prévu un circuit d'évaluation (14) qui détecte la tension au niveau du nœud de mesure (10) par l'intermédiaire de la borne de mesure (11), ce qui permet d'identifier un actionnement du dispositif d'entrée (1) et/ou un défaut du contact de commutation (3).

3. Dispositif d'entrée (1) selon l'une des revendications 1 ou 2, dans lequel le contact de commutation (3) présente une configuration en forme de dôme ou de coupole et les première et troisième bornes de connexion (4, 12) sont de préférence prévues dans des zones opposées l'une à l'autre du contact de commutation (3) en forme de dôme ou de coupole.

4. Dispositif d'entrée (1) selon l'une des revendications 1 ou 2, dans lequel le contact de commutation (3) présente une configuration plane et les première et troisième bornes de connexion (4, 12) sont de préférence prévues de manière adjacente sur un bord ou dans des zones opposées l'une à l'autre du contact de commutation (3) plan.

5. Dispositif d'entrée (1) selon l'une des revendications précédentes, dans lequel il est prévu une troisième résistance (15) entre la première borne d'alimentation en tension (7) et la borne de connexion (4, 6) respective de l'élément de commutation (2), de sorte que la borne de connexion (4, 6) respective de l'élément de commutation (2) est raccordée à la première borne d'alimentation en tension par l'intermédiaire de la troisième résistance (15).

6. Dispositif d'entrée (1) selon l'une des revendications précédentes, dans lequel la deuxième borne d'alimentation en tension (8) est raccordée à une tension de fonctionnement positive et la première borne d'alimentation en tension (7) est raccordée à un potentiel de référence du dispositif d'entrée (1), de préférence la masse.

7. Dispositif d'entrée (1) selon l'une des revendications précédentes, dans lequel, dans l'état non actionné du dispositif d'entrée (1), une tension fonction de l'actionnement (U1), qui résulte du rapport de pont diviseur de tension entre la première résistance (9) et la deuxième résistance (13) et, de préférence, la troisième résistance (15), peut être détectée au niveau du nœud de mesure (10).

8. Dispositif d'entrée (1) selon l'une des revendications précédentes, dans lequel, dans l'état actionné du dispositif d'entrée (1), une tension fonction de l'actionnement (U1), qui correspond à la tension ou au potentiel de la première borne d'alimentation en tension (7) ou qui résulte du rapport de pont diviseur de tension entre la première résistance (9) et la troisième résistance (15), peut être détectée au niveau du nœud de mesure (10).

9. Dispositif d'entrée (1) selon l'une des revendications précédentes, dans lequel, en cas de défaut du contact de commutation (3), de préférence en cas de rupture (19) du contact de commutation (3), une tension de défaut (U2), qui correspond à la tension ou au potentiel de la deuxième borne d'alimentation en tension (8), peut être détectée au niveau du nœud de mesure (10).

10. Dispositif d'entrée (1) selon l'une des revendications précédentes, dans lequel le circuit d'évaluation (14) comprend un convertisseur analogique-numérique, de sorte que la tension détectée peut être convertie en une valeur numérique et traitée numériquement.

11. Dispositif d'entrée (1) selon l'une des revendications précédentes, dans lequel, lors de l'actionnement du dispositif d'entrée (1), le contact établi entre le contact de commutation (3) et le contact homologue (5) est galvaniquement ou électriquement conducteur.

12. Dispositif d'entrée (1) selon l'une des revendications 1 à 10, dans lequel, lors de l'actionnement du dispositif d'entrée (1), le contact établi entre le contact de commutation (3) et le contact homologue (5) est résistif ou capacitif.

13. Dispositif d'entrée (1) selon l'une des revendications précédentes, dans lequel l'élément de commutation (2) et les résistances (9, 13, 15) sont agencés sur une carte de circuit imprimé (16) et au moins les première et troisième bornes de connexion (4, 12) sont de préférence réalisées sous forme de points de soudure (17) sur la carte de circuit imprimé (16).

14. Dispositif d'entrée (1) selon la revendication 13, dans lequel le contact de commutation (3) en forme de dôme ou de coupole est soudé aux points de soudure (17) pour les première et troisième bornes de connexion (4, 12) et le contact homologue (5) est prévu entre ces deux points de soudure (17) sur la carte de circuit imprimé (16).

15. Dispositif d'entrée (1) selon la revendication 14, dans lequel il est prévu sur la carte de circuit imprimé (16) d'autres points d'appui (18) pour le contact de commutation (3) en forme de dôme ou de coupole, lesquels sont de préférence réalisés sous forme de points de soudure (17).

Fig. 1a

Fig. 1b

Fig. 1c

Fig. 2a

Fig. 2b

Fig. 2c

Fig. 3a　　　　Fig. 3b　　　　Fig. 3c

Fig. 4a　　　　Fig. 4b　　　　Fig. 4c

Fig. 5a

Fig. 5b

Fig. 6a

Fig. 6b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6423918 B1
- US 7825345 B1
- US 20140144765 A1
- EP 2001034 A2
- DE 102017113905 A